(19) Europäisches Patentamt
European Patent Office
Office européen des brevets

(11) **EP 4 354 346 A1**

(12) **EUROPEAN PATENT APPLICATION**

(43) Date of publication:
**17.04.2024 Bulletin 2024/16**

(21) Application number: **22200674.4**

(22) Date of filing: **10.10.2022**

(51) International Patent Classification (IPC):
**G06N 3/0455** (2023.01)  **G06N 3/09** (2023.01)
**G01R 19/25** (2006.01)  **G05B 23/02** (2006.01)
**H02J 13/00** (2006.01)  **G01R 31/08** (2020.01)

(52) Cooperative Patent Classification (CPC):
**G06N 3/0455; G01R 19/2513; G06N 3/09;
H02J 13/00002;** G06N 20/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Hitachi Energy Ltd
8050 Zürich (CH)**

(72) Inventors:
• **CHAKRAVORTY, Jhelum**
  **H3N2B3 Montreal (CA)**
• **DAWIDOWSKI, Pawel**
  **32-010 Malopolskie (PL)**
• **POLAND, Jan**
  **5415 Nussbaumen (CH)**

(74) Representative: **Vossius & Partner
Patentanwälte Rechtsanwälte mbB
Siebertstraße 3
81675 München (DE)**

(54) **REGULARIZATION TECHNIQUES TO IMPROVE EFFICIENCY OF TIME DOMAIN PROTECTION**

(57) One component of time domain protection in a power system is estimating the location of a fault. In an embodiment, a multi-objective problem is formulated that comprises a non-smoothness penalization function that drives the primary objective function for fault location estimation towards a solution that respects smoothness between the inputs and outputs of a machine-learning model. This technique improves the accuracy, blind zone, and speed of state-of-the-art techniques, in the context of time domain protection, as well as for other regression tasks. In an additional or alternative embodiment that is specific to time domain protection, the multi-objective problem may comprise a phasor-deviation penalization function that drives the primary objective function towards a solution that minimizes deviations in phasor values. The trained machine-learning model may be executed in a line protection system to determine whether or not to trip a circuit breaker of a power line.

**FIG. 1**

## Description

## BACKGROUND

Field of the Invention

The embodiments described herein are generally directed to machine learning, and, more particularly, to an improved technique for training a machine-learning model using heterogeneous data with high dimensionality to estimate, for example, a fault location for time domain protection.

Description of the Related Art

Protection applications in a power system may be designed to isolate a faulted section of the power system, in order to limit physical damage to the infrastructure of the power system. For example, time domain protection may protect an overhead power line by detecting a fault within a protected zone (e.g., up to a set reach), and tripping a circuit breaker as quickly as possible once the fault is detected within the protected zone. Detection of the fault is generally performed using only local voltage and current measurements.

One component of time domain protection is estimation of the location of a fault. The estimation may be performed as a series-to-series transformation per sample. In particular, each measurement sample, comprising incoming voltage and current measurements, within a time series, is processed as an input to estimate a fault location per sample. A decision can then be made whether or not to trip the relevant circuit breaker, based on the estimated fault location.

This decision must be performed with high security. This means that all faults should be isolated with high dependability, which requires insensitivity for a fault or other event outside the protected zone. An example of such an event is a fault at a busbar or at any other power line close to the protected power line. The final decision, as to whether or not to trip the relevant circuit breaker, may be based on a plurality of factors, such as fault detection, the fault direction, a reach calculation, and a security counter.

The main challenge in estimating a fault location is that the estimation of the fault location must be both highly precise and fast. The state-of-the-art approach is to estimate an equivalent system equation for each sample by solving a set of differential equations, estimating instantaneous impedance of the power line, which contains information about the fault location, and then comparing the estimated instantaneous impedance to relevant margins. The present disclosure is directed toward overcoming one or more problems discovered by the inventors.

## SUMMARY

Accordingly, systems, methods, and non-transitory computer-readable media are disclosed to train a machine-learning model using heterogeneous data with high dimensionality to, for example, estimate a fault location for time domain protection.

In an embodiment, a method of manifold regularization while training a machine-learning model, comprises using at least one hardware processor to: acquire a training dataset that comprises a plurality of feature sets, wherein each of the plurality of feature sets comprises a feature value for each of a plurality of features and is labeled with a target value for each of one or more targets; generate an optimization problem comprising an objective function and a non-smoothness penalization function, wherein the objective function calculates an estimated error between the target values and corresponding output values that the machine-learning model outputs for the plurality of feature sets, and wherein the non-smoothness penalization function is configured to increase the estimated error in the optimization problem as a smoothness of the machine-learning model decreases; and train the machine-learning model by adjusting the machine-learning model to minimize the estimated error, produced by the training dataset, in the optimization problem. The non-smoothness penalization function may comprise a Laplacian norm of the output values. The non-smoothness penalization function may approximate a gradient of the machine-learning model on a data manifold of the machine-learning model.

Training the machine-learning model may comprise: clustering the training dataset into a plurality of clusters, wherein the non-smoothness penalization function associates a weight with each of the plurality of clusters; and adaptively learning the weights for the plurality of clusters. Adaptively learning the weights for the plurality of clusters may comprise, for each of a plurality of outer iterations: determining the weights for the plurality of clusters; and for each of a plurality of inner iterations, adjusting the machine-learning model to minimize the estimated error, produced by the training dataset, in the optimization problem, using the determined weights for the plurality of clusters in the non-smoothness penalization function. The weights for the plurality of clusters may be determined in each of the plurality of outer iterations using a multi-class classification algorithm. The machine-learning model may be adjusted in each of the plurality of inner iterations using a regression algorithm.

The method may further comprise using the at least one hardware processor to, prior to acquiring the training dataset, acquire data having a first dimensionality, and embed the data into a lower dimensional space having a second dimensionality that is lower than the first dimensionality, wherein the training dataset is acquired from the data in the lower dimensional space.

Each of the plurality of feature sets may represent a set of measurement signals for a power line, wherein each target value represents a fault location on the power line. The method may further comprise, by a protection device: receiving measurement signals from a plurality of sensors connected to the power line; applying the trained machine-learning model to the measurement signals to estimate a fault location on the power line; comparing the estimated fault location to a threshold; and when the estimated fault location satisfies the threshold, tripping at least one circuit breaker to electrically isolate the fault location on the power line.

Each of the plurality of feature sets may represent a set of measurement signals for a power line, wherein each target value represents a decision to either trip or not trip a circuit breaker on the power line.

Each of the plurality of feature sets may represent a state of a power system, wherein each target value represents a value of a continuous variable of the power system, and wherein the method further comprises using the trained machine-learning model to estimate the value of the continuous variable.

The method may further comprise using the trained machine-learning model for one of topology estimation, parameter estimation, power flow estimation, or load forecasting.

Each of at least a subset of the plurality of feature sets in the training dataset may be labeled with a ground-truth phasor value, wherein the optimization problem further comprises a phasor-deviation penalization function that is configured to increase the estimated error in the optimization problem as a difference between an estimated phasor value, output by an encoder network, and the ground-truth phasor value, for each of the at least a subset of the plurality of features sets in the training dataset, increases. The at least a subset of the plurality of feature sets in the training dataset may consist of only a portion of the plurality of feature sets in the training dataset that comprises, for each of the plurality of features, a time series that encompasses at least a predefined length of time. The encoder network may be an artificial neural network.

In an embodiment, a method of manifold regularization while training a machine-learning model, comprises using at least one hardware processor to: acquire a training dataset that comprises a plurality of feature sets, wherein each of the plurality of feature sets comprises a feature value for each of a plurality of features and is labeled with a target value for each of one or more targets, and wherein each of at least a subset of the plurality of feature sets is labeled with a ground-truth phasor value; generate an optimization problem comprising an objective function and a phasor-deviation penalization function, wherein the objective function calculates an estimated error between the target values and corresponding output values that the machine-learning model outputs for the plurality of feature sets, and wherein the phasor-deviation penalization function is configured to increase the estimated error in the optimization problem as a difference between an estimated phasor value, output by an encoder network, and a ground-truth phasor value, for each of the at least a subset of the plurality of features sets in the training dataset, increases; and train the machine-learning model by adjusting the machine-learning model to minimize the estimated error, produced by the training dataset, in the optimization problem. The at least a subset of the plurality of feature sets in the training dataset may consist of only a portion of the plurality of feature sets in the training dataset that comprises, for each of the plurality of features, a time series that encompasses at least a predefined length of time.

It should be understood that any of the features in the methods above may be implemented individually or with any subset of the other features in any combination. Thus, to the extent that the appended claims would suggest particular dependencies between features, disclosed embodiments are not limited to these particular dependencies. Rather, any of the features described herein may be combined with any other feature described herein, or implemented without any one or more other features described herein, in any combination of features whatsoever. In addition, any of the methods, described above and elsewhere herein, may be embodied, individually or in any combination, in executable software modules of a processor-based system, such as a server, and/or in executable instructions stored in a non-transitory computer-readable medium.

## BRIEF DESCRIPTION OF THE DRAWINGS

The details of the present invention, both as to its structure and operation, may be gleaned in part by study of the accompanying drawings, in which like reference numerals refer to like parts, and in which:

FIG. 1 illustrates an example infrastructure, in which one or more of the processes described herein, may be implemented, according to an embodiment;
FIG. 2 illustrates an example processing system, by which one or more of the processes described herein, may be executed, according to an embodiment;
FIG. 3 illustrates the operation of a line protection system, according to an embodiment;

FIG. 4 illustrates a process for training a machine-learning model, according to an embodiment;
FIG. 5 illustrates an example of a training subprocess which utilizes bi-level optimization, according to an embodiment;
FIGS. 6A and 6B illustrate encoder-decoder architectures, according to alternative embodiments;
FIGS. 7A and 7B illustrate the blind zones for a machine-learning model trained with Laplace regularization, according to an embodiment, and without Laplace regularization, respectively; and
FIG. 8 illustrates a process for making a trip decision, according to an embodiment.

**DETAILED DESCRIPTION**

In an embodiment, systems, methods, and non-transitory computer-readable media are disclosed for training a machine-learning model using heterogeneous data with high dimensionality to, for example, estimate a fault location for time domain protection. After reading this description, it will become apparent to one skilled in the art how to implement the invention in various alternative embodiments and alternative applications. However, although various embodiments of the present invention will be described herein, it is understood that these embodiments are presented by way of example and illustration only, and not limitation. As such, this detailed description of various embodiments should not be construed to limit the scope or breadth of the present invention as set forth in the appended claims.

1. System Overview

1.1. Infrastructure

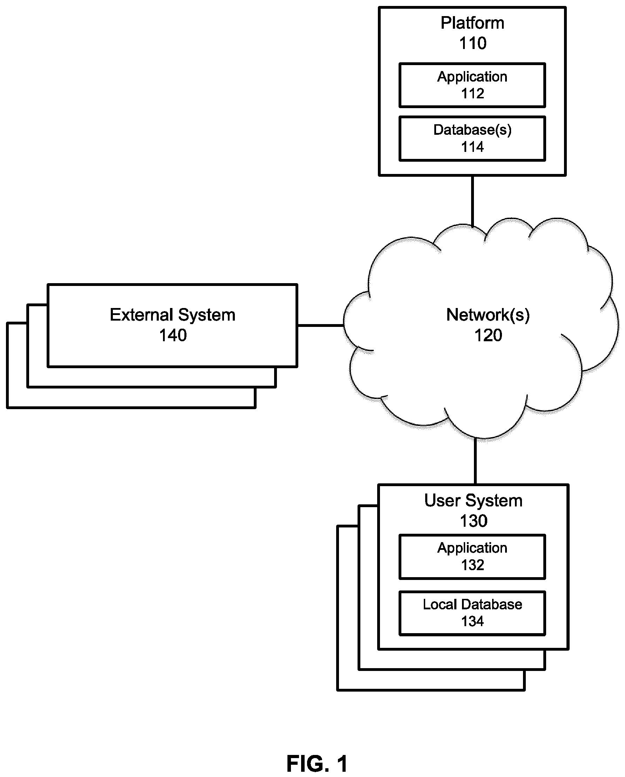

FIG. 1 illustrates an example infrastructure in which one or more of the disclosed processes may be implemented, according to an embodiment. The infrastructure may comprise a platform 110 (e.g., one or more servers) which hosts and/or executes one or more of the various functions, processes, methods, and/or software modules described herein. Platform 110 may comprise dedicated servers, or may instead be implemented in a computing cloud, in which the resources of one or more servers are dynamically and elastically allocated to multiple tenants based on demand. In either case, the servers may be collocated and/or geographically distributed. Platform 110 may also comprise or be communicatively connected to a server application 112 and/or one or more databases 114. In addition, platform 110 may be communicatively connected to one or more user systems 130 via one or more networks 120. Platform 110 may also be communicatively connected to one or more external systems 140 (e.g., other platforms, websites, etc.) via one or more networks 120.
Network(s) 120 may comprise the Internet, and platform 110 may communicate with user system(s) 130 through the Internet using standard transmission protocols, such as HyperText Transfer Protocol (HTTP), HTTP Secure (HTTPS), File Transfer Protocol (FTP), FTP Secure (FTPS), Secure Shell FTP (SFTP), and the like, as well as proprietary protocols. While platform 110 is illustrated as being connected to various systems through a single set of network(s) 120, it should be understood that platform 110 may be connected to the various systems via different sets of one or more networks. For example, platform 110 may be connected to a subset of user systems 130 and/or external systems 140 via the Internet, but may be connected to one or more other user systems 130 and/or external systems 140 via an intranet. Furthermore, while only a few user systems 130 and external systems 140, one server application 112, and one set of database(s) 114 are illustrated, it should be understood that the infrastructure may comprise any number of user systems, external systems, server applications, and databases.
User system(s) 130 may comprise any type or types of computing devices capable of wired and/or wireless communication, including without limitation, desktop computers, laptop computers, tablet computers, smart phones or other mobile phones, servers, game consoles, televisions, set-top boxes, electronic kiosks, point-of-sale terminals, and/or the like. However, it is generally contemplated that a user system 130 would be the personal computer or workstation of an administrator tasked with training a machine-learning model and/or deploying a trained machine-learning model (e.g., to one or more line protection systems comprised in an external system 140). Each user system 130 may comprise or be communicatively connected to a client application 132 and/or one or more local databases 134.
Platform 110 may comprise web servers which host one or more websites and/or web services. In embodiments in which a website is provided, the website may comprise a graphical user interface, including, for example, one or more screens (e.g., webpages) generated in HyperText Markup Language (HTML) or other language. Platform 110 transmits or serves one or more screens of the graphical user interface in response to requests from user system(s) 130. In some embodiments, these screens may be served in the form of a wizard, in which case two or more screens may be served in a sequential manner, and one or more of the sequential screens may depend on an interaction of the user or user system 130 with one or more preceding screens. The requests to platform 110 and the responses from platform 110, including the screens of the graphical user interface, may both be communicated through network(s) 120, which may include the Internet, using standard communication protocols (e.g., HTTP, HTTPS, etc.). These screens (e.g., webpages) may comprise a combination of content and elements, such as text, images, videos, animations, references (e.g.,

hyperlinks), frames, inputs (e.g., textboxes, text areas, checkboxes, radio buttons, drop-down menus, buttons, forms, etc.), scripts (e.g., JavaScript), and the like, including elements comprising or derived from data stored in one or more databases (e.g., database(s) 114) that are locally and/or remotely accessible to platform 110. It should be understood that platform 110 may also respond to other requests from user system(s) 130.

Platform 110 may comprise, be communicatively coupled with, or otherwise have access to one or more database(s) 114. For example, platform 110 may comprise one or more database servers which manage one or more databases 114. Server application 112 executing on platform 110 and/or client application 132 executing on user system 130 may submit data (e.g., user data, form data, etc.) to be stored in database(s) 114, and/or request access to data stored in database(s) 114. Any suitable database may be utilized, including without limitation MySQL™, Oracle™, IBM™, Microsoft SQL™, Access™, PostgreSQL™, MongoDB™, and the like, including cloud-based databases and proprietary databases. Data may be sent to platform 110, for instance, using the well-known POST request supported by HTTP, via FTP, and/or the like. This data, as well as other requests, may be handled, for example, by server-side web technology, such as a servlet or other software module (e.g., comprised in server application 112), executed by platform 110.

In embodiments in which a web service is provided, platform 110 may receive requests from external system(s) 140, and provide responses in extensible Markup Language (XML), JavaScript Object Notation (JSON), and/or any other suitable or desired format. In such embodiments, platform 110 may provide an application programming interface (API) which defines the manner in which user system(s) 130 and/or external system(s) 140 may interact with the web service. Thus, user system(s) 130 and/or external system(s) 140 (which may themselves be servers), can define their own user interfaces, and rely on the web service to implement or otherwise provide the backend processes, methods, functionality, storage, and/or the like, described herein. For example, in such an embodiment, a client application 132, executing on one or more user system(s) 130, may interact with a server application 112 executing on platform 110 to execute one or more or a portion of one or more of the various functions, processes, methods, and/or software modules described herein. In an embodiment, client application 132 may utilize a local database 134 for storing data locally on user system 130.

Client application 132 may be "thin," in which case processing is primarily carried out server-side by server application 112 on platform 110. A basic example of a thin client application 132 is a browser application, which simply requests, receives, and renders webpages at user system(s) 130, while server application 112 on platform 110 is responsible for generating the webpages and managing database functions. Alternatively, the client application may be "thick," in which case processing is primarily carried out client-side by user system(s) 130. It should be understood that client application 132 may perform an amount of processing, relative to server application 112 on platform 110, at any point along this spectrum between "thin" and "thick," depending on the design goals of the particular implementation. In any case, the software described herein, which may wholly reside on either platform 110 (e.g., in which case server application 112 performs all processing) or user system(s) 130 (e.g., in which case client application 132 performs all processing) or be distributed between platform 110 and user system(s) 130 (e.g., in which case server application 112 and client application 132 both perform processing), can comprise one or more executable software modules comprising instructions that implement one or more of the processes, methods, or functions described herein.

### 1.2. Example Processing Device

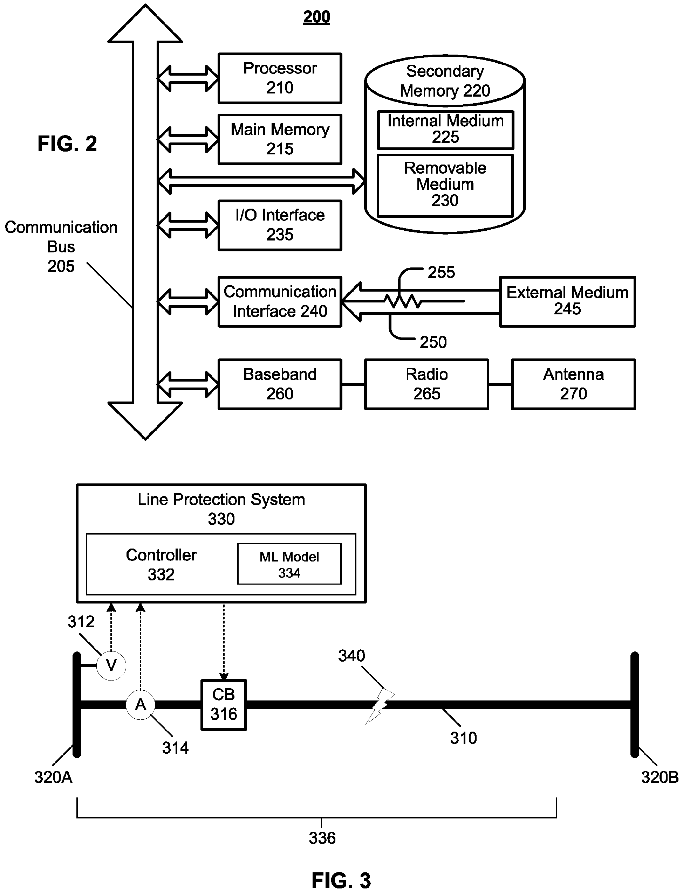

FIG. 2 is a block diagram illustrating an example wired or wireless system 200 that may be used in connection with various embodiments described herein. For example, system 200 may be used as or in conjunction with one or more of the functions, processes, or methods (e.g., to store and/or execute the software) described herein, and may represent components of platform 110, user system(s) 130, external system(s) 140, a line protection system, and/or other processing devices described herein. System 200 can be a server or any conventional personal computer, or any other processor-enabled device that is capable of wired or wireless data communication. Other computer systems and/or architectures may be also used, as will be clear to those skilled in the art.

System 200 preferably includes one or more processors 210. Processor(s) 210 may comprise a central processing unit (CPU). Additional processors may be provided, such as a graphics processing unit (GPU), an auxiliary processor to manage input/output, an auxiliary processor to perform floating-point mathematical operations, a special-purpose microprocessor having an architecture suitable for fast execution of signal-processing algorithms (e.g., digital-signal processor), a slave processor subordinate to the main processing system (e.g., back-end processor), an additional microprocessor or controller for dual or multiple processor systems, and/or a coprocessor. Such auxiliary processors may be discrete processors or may be integrated with processor 210. Examples of processors which may be used with system 200 include, without limitation, any of the processors (e.g., Pentium™, Core i7™, Xeon™, etc.) available from Intel Corporation of Santa Clara, California, any of the processors available from Advanced Micro Devices, Incorporated (AMD) of Santa Clara, California, any of the processors (e.g., A series, M series, etc.) available from Apple Inc. of Cupertino, any of the processors (e.g., Exynos™) available from Samsung Electronics Co., Ltd., of Seoul, South Korea, any of the processors available from NXP Semiconductors N.V. of Eindhoven, Netherlands, and/or the like.

Processor 210 is preferably connected to a communication bus 205. Communication bus 205 may include a data channel for facilitating information transfer between storage and other peripheral components of system 200. Furthermore, communication bus 205 may provide a set of signals used for communication with processor 210, including a data bus, address bus, and/or control bus (not shown). Communication bus 205 may comprise any standard or non-standard bus architecture such as, for example, bus architectures compliant with industry standard architecture (ISA), extended industry standard architecture (EISA), Micro Channel Architecture (MCA), peripheral component interconnect (PCI) local bus, standards promulgated by the Institute of Electrical and Electronics Engineers (IEEE) including IEEE 488 general-purpose interface bus (GPIB), IEEE 696/S-100, and/or the like.

System 200 preferably includes a main memory 215 and may also include a secondary memory 220. Main memory 215 provides storage of instructions and data for programs executing on processor 210, such as any of the software discussed herein. It should be understood that programs stored in the memory and executed by processor 210 may be written and/or compiled according to any suitable language, including without limitation C/C++, Java, JavaScript, Perl, Visual Basic, .NET, and the like. Main memory 215 is typically semiconductor-based memory such as dynamic random access memory (DRAM) and/or static random access memory (SRAM). Other semiconductor-based memory types include, for example, synchronous dynamic random access memory (SDRAM), Rambus dynamic random access memory (RDRAM), ferroelectric random access memory (FRAM), and the like, including read only memory (ROM).

Secondary memory 220 is a non-transitory computer-readable medium having computer-executable code (e.g., any of the software disclosed herein) and/or other data stored thereon. The computer software or data stored on secondary memory 220 is read into main memory 215 for execution by processor 210. Secondary memory 220 may include, for example, semiconductor-based memory, such as programmable read-only memory (PROM), erasable programmable read-only memory (EPROM), electrically erasable read-only memory (EEPROM), and flash memory (block-oriented memory similar to EEPROM).

Secondary memory 220 may optionally include an internal medium 225 and/or a removable medium 230. Removable medium 230 is read from and/or written to in any well-known manner. Removable storage medium 230 may be, for example, a magnetic tape drive, a compact disc (CD) drive, a digital versatile disc (DVD) drive, other optical drive, a flash memory drive, and/or the like.

In alternative embodiments, secondary memory 220 may include other similar means for allowing computer programs or other data or instructions to be loaded into system 200. Such means may include, for example, a communication interface 240, which allows software and data to be transferred from external storage medium 245 to system 200. Examples of external storage medium 245 include an external hard disk drive, an external optical drive, an external magnetooptical drive, and/or the like.

As mentioned above, system 200 may include a communication interface 240. Communication interface 240 allows software and data to be transferred between system 200 and external devices (e.g. printers), networks, or other information sources. For example, computer software or executable code may be transferred to system 200 from a network server (e.g., platform 110) via communication interface 240. Examples of communication interface 240 include a built-in network adapter, network interface card (NIC), Personal Computer Memory Card International Association (PCMCIA) network card, card bus network adapter, wireless network adapter, Universal Serial Bus (USB) network adapter, modem, a wireless data card, a communications port, an infrared interface, an IEEE 1394 fire-wire, and any other device capable of interfacing system 200 with a network (e.g., network(s) 120) or another computing device. Communication interface 240 preferably implements industry-promulgated protocol standards, such as Ethernet IEEE 802 standards, Fiber Channel, digital subscriber line (DSL), asynchronous digital subscriber line (ADSL), frame relay, asynchronous transfer mode (ATM), integrated digital services network (ISDN), personal communications services (PCS), transmission control protocol/Internet protocol (TCP/IP), serial line Internet protocol/point to point protocol (SLIP/PPP), and so on, but may also implement customized or non-standard interface protocols as well.

Software and data transferred via communication interface 240 are generally in the form of electrical communication signals 255. These signals 255 may be provided to communication interface 240 via a communication channel 250. In an embodiment, communication channel 250 may be a wired or wireless network (e.g., network(s) 120), or any variety of other communication links. Communication channel 250 carries signals 255 and can be implemented using a variety of wired or wireless communication means including wire or cable, fiber optics, conventional phone line, cellular phone link, wireless data communication link, radio frequency ("RF") link, or infrared link, just to name a few.

Computer-executable code (e.g., computer programs, such as the disclosed software) is stored in main memory 215 and/or secondary memory 220. Computer-executable code can also be received via communication interface 240 and stored in main memory 215 and/or secondary memory 220. Such computer programs, when executed, enable system 200 to perform the various functions of the disclosed embodiments as described elsewhere herein.

In this description, the term "computer-readable medium" is used to refer to any non-transitory computer-readable storage media used to provide computer-executable code and/or other data to or within system 200. Examples of such media include main memory 215, secondary memory 220 (including internal memory 225 and/or removable medium 230), external storage medium 245, and any peripheral device communicatively coupled with communication interface 240 (including a network information server or other network device). These non-transitory computer-readable media are means for providing software and/or other data to system 200.

In an embodiment that is implemented using software, the software may be stored on a computer-readable medium and loaded into system 200 by way of removable medium 230, I/O interface 235, or communication interface 240. In such an embodiment, the software is loaded into system 200 in the form of electrical communication signals 255. The software, when executed by processor 210, preferably causes processor 210 to perform one or more of the processes and functions described elsewhere herein.

In an embodiment, I/O interface 235 provides an interface between one or more components of system 200 and one or more input and/or output devices. Example input devices include, without limitation, sensors, keyboards, touch screens or other touch-sensitive devices, cameras, biometric sensing devices, computer mice, trackballs, pen-based pointing devices, and/or the like. Examples of output devices include, without limitation, other processing devices, cathode ray tubes (CRTs), plasma displays, light-emitting diode (LED) displays, liquid crystal displays (LCDs), printers, vacuum fluorescent displays (VFDs), surface-conduction electron-emitter displays (SEDs), field emission displays (FEDs), and/or the like. In some cases, an input and output device may be combined, such as in the case of a touch panel display (e.g., in a smartphone, tablet, or other mobile device).

System 200 may also include optional wireless communication components that facilitate wireless communication over a voice network and/or a data network (e.g., in the case of user system 130). The wireless communication components comprise an antenna system 270, a radio system 265, and a baseband system 260. In system 200, radio frequency (RF) signals are transmitted and received over the air by antenna system 270 under the management of radio system 265.

In an embodiment, antenna system 270 may comprise one or more antennae and one or more multiplexors (not shown) that perform a switching function to provide antenna system 270 with transmit and receive signal paths. In the receive path, received RF signals can be coupled from a multiplexor to a low noise amplifier (not shown) that amplifies the received RF signal and sends the amplified signal to radio system 265.

In an alternative embodiment, radio system 265 may comprise one or more radios that are configured to communicate over various frequencies. In an embodiment, radio system 265 may combine a demodulator (not shown) and modulator (not shown) in one integrated circuit (IC). The demodulator and modulator can also be separate components. In the incoming path, the demodulator strips away the RF carrier signal leaving a baseband receive audio signal, which is sent from radio system 265 to baseband system 260.

If the received signal contains audio information, then baseband system 260 decodes the signal and converts it to an analog signal. Then the signal is amplified and sent to a speaker. Baseband system 260 also receives analog audio signals from a microphone. These analog audio signals are converted to digital signals and encoded by baseband system 260. Baseband system 260 also encodes the digital signals for transmission and generates a baseband transmit audio signal that is routed to the modulator portion of radio system 265. The modulator mixes the baseband transmit audio signal with an RF carrier signal, generating an RF transmit signal that is routed to antenna system 270 and may pass through a power amplifier (not shown). The power amplifier amplifies the RF transmit signal and routes it to antenna system 270, where the signal is switched to the antenna port for transmission.

Baseband system 260 is also communicatively coupled with processor(s) 210. Processor(s) 210 may have access to data storage areas 215 and 220. Processor(s) 210 are preferably configured to execute instructions (i.e., computer programs, such as the disclosed software) that can be stored in main memory 215 or secondary memory 220. Computer programs can also be received from baseband processor 260 and stored in main memory 210 or in secondary memory 220, or executed upon receipt. Such computer programs, when executed, can enable system 200 to perform the various functions of the disclosed embodiments.

1.3. Line Protection System

FIG. 3 illustrates the operation of a line protection system 330, according to an embodiment. An electrical power line 310 may be provided between two substations 320A and 320B. One or more voltage measurement units 312 may measure voltage on power line 310 and output the voltage measurements to line protection system 330. In addition, one or more current measurement units 314 may measure current on power line 310 and output the current measurements to line protection system 330.

Line protection system 330 may comprise a controller 332, which may implement system 200 or some subset thereof. For example, controller 332 may comprise one or more processors 210 and store a machine-learning (ML) model 334 in memory (e.g., main memory 215 and/or secondary memory 220). Controller 332 may receive the voltage measurements from voltage measurement unit(s) 312, the current measurements from current measurement unit(s) 314, and/or other measurements from one or more other sensors or devices related to power line 310. Controller 332 could also derive one or more additional measurements from the received measurements.

Controller 332 may apply machine-learning model 334 to the measurements as part of a time domain protection scheme. For example, the measurements may be input to machine-learning model 334 to estimate a location of a fault 340 or output a decision of whether or not to trip (i.e., open) a circuit breaker 316 on power line 310. If the location of fault 340 is within a protection zone, defined by a reach setting 336, of line protection system 330, controller 332 may determine to trip circuit breaker 316 (i.e., switch circuit breaker 316 to an open state). Otherwise, controller 332 may determine not to trip circuit breaker 316 (i.e., maintain circuit breaker 316 in a closed state). When controller 332 determines to trip circuit breaker 316, controller 332 may send a control signal to circuit breaker 316 (e.g., directly or via a relay controlling circuit breaker 316) to open circuit breaker 316 and thereby isolate fault 340 from substation 320A. It should be understood that there may be a similar line protection system 330 on the other end of power line 110 that may perform the same function to isolate fault 340 from substation 320B, if the location of fault 340 is within its respective protection zone.

## 2. Process Overview

Embodiments of processes for training a machine-learning model 334 using heterogeneous data with high dimensionality to, for example, estimate a fault location for time domain protection will now be described in detail. It should be understood that the described processes may be embodied in one or more software modules that are executed by one or more hardware processors (e.g., processor 210), for example, as a software application (e.g., server application 112, client application 132, and/or a distributed application comprising both server application 112 and client application 132), which may be executed wholly by processor(s) of platform 110, wholly by processor(s) of user system(s) 130, or may be distributed across platform 110 and user system(s) 130, such that some portions or modules of the software application are executed by platform 110 and other portions or modules of the software application are executed by user system(s) 130. The described processes may be implemented as instructions represented in source code, object code, and/or machine code. These instructions may be executed directly by hardware processor(s) 210, or alternatively, may be executed by a virtual machine operating between the object code and hardware processor(s) 210. In addition, the disclosed software may be built upon or interfaced with one or more existing systems.

Alternatively, the described processes may be implemented as a hardware component (e.g., general-purpose processor, integrated circuit (IC), application-specific integrated circuit (ASIC), digital signal processor (DSP), field-programmable gate array (FPGA) or other programmable logic device, discrete gate or transistor logic, etc.), combination of hardware components, or combination of hardware and software components. To clearly illustrate the interchangeability of hardware and software, various illustrative components, blocks, modules, circuits, and steps are described herein generally in terms of their functionality. Whether such functionality is implemented as hardware or software depends upon the particular application and design constraints imposed on the overall system. Skilled persons can implement the described functionality in varying ways for each particular application, but such implementation decisions should not be interpreted as causing a departure from the scope of the invention. In addition, the grouping of functions within a component, block, module, circuit, or step is for ease of description. Specific functions or steps can be moved from one component, block, module, circuit, or step to another without departing from the invention.

Furthermore, while the processes, described herein, are illustrated with a certain arrangement and ordering of subprocesses, each process may be implemented with fewer, more, or different subprocesses and a different arrangement and/or ordering of subprocesses. In addition, it should be understood that any subprocess, which does not depend on the completion of another subprocess, may be executed before, after, or in parallel with that other independent subprocess, even if the subprocesses are described or illustrated in a particular order.

## 2.1. Heterogeneous Data with High Dimensionality

Regression problems in certain contexts, such as reach calculations for time domain protection, frequently use data with high dimensionality, due to the large number of features that must be considered. For example, the features may comprise many channels that include buffers of previous values. As a result, the data manifold (i.e., the space in which the data sits) can be quite complex, which makes it difficult to perform supervised learning, such as a regression. Accordingly, in an embodiment, information about the smoothness of the data manifold and the interconnectivity of the features in the data are added to the learning of the input-output mapping for machine-learning model 334.

In addition, this highly dimensional data is often hugely heterogeneous. This is due to varying simulation parameters, varying collection processes, different data sources, and/or the like. The heterogeneity of the data can impede the estimation of fault location, due to limitations of the model in capturing the complexity of information hidden in the data. In the context of time domain protection, such a scenario may arise when the data are gathered from several data sources (e.g., different towers or other sources in a power transmission system) with widely varying system parameters and signals. Accordingly, in an embodiment, the heterogeneous data are divided into relatively more homogenous subgroups or "clusters" to ease the training (e.g., reduce underfitting) of machine-learning model 334.

## 2.2. Multi-Objective Optimization

To increase the prediction accuracy of a machine-learning model 334, denoted as a function $f_\theta$, its estimation error should be minimized. Furthermore, when the target of machine-learning model 334 is a continuous variable (e.g., when machine-learning model 334 estimates a fault location), function $f_\theta$ should be smooth on the input features. For example, in the context of time domain protection, the fault location (i.e., the target) estimated by function $f_\theta$ should change smoothly across changes in the measurement samples (i.e., the input features). Thus, in an embodiment, machine-learning model 334 is trained by minimizing the following multi-objective optimization problem:

$$P: \quad \min_\theta \left( \|Y - f_\theta(X)\|^2 + g_\theta(X) \right)$$

wherein $X$ represents the set of input features in the training dataset, $Y$ represents the set of ground-truth targets in the training dataset, and $g_\theta$ denotes a non-smoothness penalization function. It should be understood that the training dataset may comprise features $X$, comprising a plurality of feature sets $\{x_1, x_2, ... x_n\}$ that each comprise features. In other words, each $x_i = \{feature_1, feature_2, ... feature_m\}$. In addition, the training dataset comprises ground-truth targets $Y$, comprising a plurality of target values $\{y_1, y_2, ... y_n\}$. Each feature set $x_i$ in $X$ is labeled with a corresponding ground-truth target $y_i$ in $Y$. Notably, problem $P$ is a multi-objective optimization problem, because there are multiple objective functions, $\|Y - f_\theta(X)\|^2$ and $g_\theta(X)$, being minimized.

Additionally or alternatively, the multi-objective optimization problem may be regularized to approximate quantities which are known to be useful for the prediction task performed by $f_\theta(X)$. In particular, voltage and current phasors are known to be useful for time domain protection. However, in order for phasors to be reliably computed from a time series of voltage and current measurements, a longer time series is required than is usually feasible at the speed that a tripping decision must be made. In an embodiment, to order to overcome this problem, machine-learning model 334 is trained by minimizing the following multi-objective optimization problem:

$$P: \quad \min_\theta \left( \|Y - f_\theta(X)\|^2 + h_\theta(X) \right)$$

wherein $h_\theta$ denotes a phasor-deviation penalization function. Again, problem $P$ is a multi-objective optimization problem, because there are multiple objective functions, $\|Y - f_\theta(X)\|^2$ and $h_\theta(X)$, being minimized.

In an embodiment, the multi-objective optimization problem may combine both a non-smoothness penalization function $g_\theta$ and a phasor-deviation penalization function $h_\theta$, as follows:

$$P: \quad \min_\theta \left( \|Y - f_\theta(X)\|^2 + g_\theta(X) + h_\theta(X) \right)$$

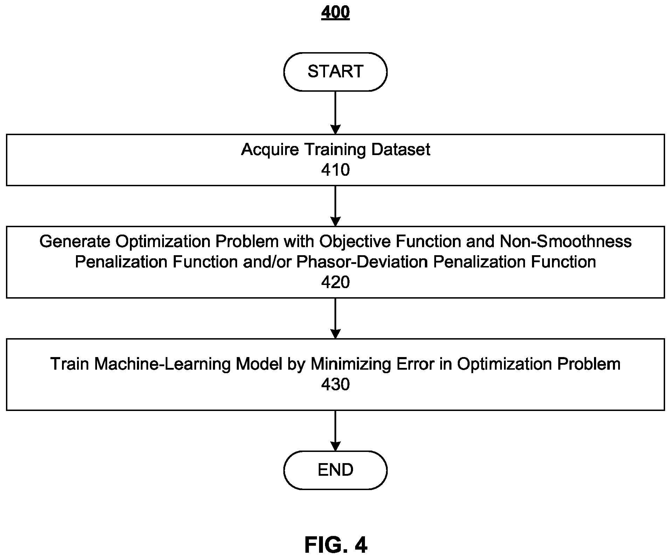

FIG. 4 illustrates a process 400 for training machine-learning model 334, according to an embodiment. Process 400 may be implemented within server application 112 on platform 110, within client application 132 on user system 130, and/or distributed between server application 112 and client application 132.

In subprocess 410, a training dataset is acquired. The training dataset comprises a plurality of feature sets $X$ that each comprise a feature value for each of a plurality of features and is labeled with a target value for each of one or more targets $Y$. In the context of time domain protection, each feature set in $X$ may represent a set of measurement signals for power line 310 (e.g., voltage measurements from voltage measurement unit 312, current measurements from current measurement unit 314, etc.). Each target in $Y$ may represent a ground-truth fault location on power line 310 or a ground-truth trip decision.

In an embodiment, data having a first dimensionality is acquired and embedded into a lower dimensional space having a second dimensionality that is lower than the first dimensionality. The training dataset is then acquired from the data in this lower dimensional space. In other words, the dimensionality of the data is reduced for the training dataset. In this case, it should be understood that the dimensionality of input data may be similarly reduced during operation of machine-learning model 334.

In subprocess 420, an optimization problem is generated with an objective function (e.g., $\|Y - f_\theta(X)\|^2$), wherein $f_\theta$ denotes machine-learning model 334. In addition, the optimization problem is generated with one or both of a non-smoothness penalization function $g_\theta$ or a phasor-deviation penalization function $h_\theta$, as discussed above.

In subprocess 430, machine-learning model 334 is trained by minimizing the error in the optimization problem, generated in subprocess 420. It should be understood that the error is represented by the objective function which calculates a difference between the ground truth and the output of machine-learning model 334. In addition, in the event that non-smoothness penalization function $g_\theta$ is included in the optimization problem, this error increases as smoothness of $f_\theta$ decreases. In the event that phasor-deviation penalization function $h_\theta$ is included in the optimization problem, this error increases as the deviations from ground-truth phasor values increases. Thus, minimization of the error in the optimization problem includes minimizing the non-smoothness of $f_\theta$ and/or minimizing the deviations in phasor values.

Once machine-learning model 334 has been trained, machine-learning model 334 may be deployed. For example, machine-learning model 334 may be stored in the memory of a controller 332 of one or more line protection systems 330. Controller 332 may apply machine-learning model 334 to real-time inputs (e.g., measurement signals acquired from measurement units 312 and 314) to estimate the location of faults on power line 310, make a decision as to whether or not to trip circuit breaker 316, or otherwise inform a time domain protection scheme implemented by controller 332.

2.3. Non-Smoothness Penalization

Non-smoothness penalization function $g_\theta$ provides manifold regularization by assuming that the data manifold $M$, in which the data is embedded, is inherently smooth. Non-smoothness penalization function $g_\theta$ is configured to measure the extent of non-smoothness of function $f_\theta$ with respect to the data, with higher values representing greater non-smoothness and lower values representing greater smoothness. Thus, non-smoothness penalization function $g_\theta$ penalizes non-smoothness in function $f_\theta$. It should be understood that the smoothness of a function is a property that is measured based on the number of continuous derivatives that the function has over some domain. Conceptually, smoothness means that small variations in the input to machine-learning model 334 do not produce large variations in the output of machine-learning model 334.

In an embodiment, non-smoothness penalization function $g_\theta$ comprises the Laplacian norm of function $f_\theta$. However, non-smoothness penalization function $g_\theta$ may be any function whose output increases as non-smoothness in function $f_\theta$ increases. For example, non-smoothness penalization function $g_\theta$ could be implemented, instead, as a Lipschitz-continuity constraint.

In an embodiment in which non-smoothness penalization function $g_\theta$ is the Laplacian norm of function $f_\theta$:

$$g_\theta(X) = \|f_\theta(X)\|^2_{\mathcal{L}(X)}$$

wherein $\mathcal{L}(X)$ denotes the Laplacian of the data matrix represented in $X$. In other words, $\mathcal{L}(X)$ is the Laplacian matrix associated with the neighborhood graph computed on $X$. Given a simple graph $G$ with $n$ nodes, the Laplacian matrix $L_{nxn}$ that is associated with graph G is defined as $L := D - A$, in which $D$ is the degree matrix and $A$ is the adjacency matrix of $G$. The expression $\|f_\theta(X)\|^2_{\mathcal{L}(X)}$ is the Laplacian norm of the predicted targets (e.g., fault locations):

$$\|f_\theta(X)\|^2_{\mathcal{L}(X)} := \left(f_\theta(X)\right)^T \mathcal{L}(X) f_\theta(X)$$

This formulation of non-smoothness penalization function $g_\theta$ can be viewed as a special case of the Lagrange relaxation of a smoothness-constrained regression problem, in which the Lagrange multiplier $\lambda = 1$.

In this embodiment, the manifold regularization becomes a Laplace regularization. The Laplacian of the input features $X$ captures the spectral composition of the data manifold $M$ in which these input features $X$ are embedded. When the input data is dense, a smooth function changes slowly with variations in the input data. Thus, penalizing non-smoothness of function $f_\theta$ is equivalent to minimizing the Laplacian norm of function $f_\theta$. Minimizing the Laplacian norm of function $f_\theta$, representing the prediction of the machine-learning model, ensures that the predicted target (e.g., estimated fault location) respects the correspondence (i.e., the smoothness) with the input data (e.g., features derived from measurement samples) and its spectral distribution.

When the distances between data points in the training dataset are interpreted as a graph, the Laplacian matrix of this graph can help estimate the marginal distribution of the data manifold $M$, in which the data points are embedded and which is otherwise unknown. As the number of data points increases, the Laplacian matrix $L$ converges to the Laplace-Beltrami operator $\Delta M$, which is the divergence of the gradient $\nabla M$. Consequently, $\|f_\theta(X)\|^2_{\mathcal{L}(X)}$ approximates

the gradient of the target function *f* on the data manifold M, as given by:

$$\|f\|_M := \int_{x \in M} \|\nabla_M f(x)\|^2 dP_x(x)$$

wherein $dP_x(x)$ represents a small slice of the probability density of *x*.

2.4. Clustering to Improve Robustness

In Laplace regularization, the entire data matrix is used to compute the Laplacian norm of the machine-learning model's predictions. While this forces the machine-learning regression model to learn a smooth function $f_\theta$, the learning is based on the spectral distribution of the entire input data as a whole. For a complex training dataset with significant heterogeneity, the machine-learning model will often fail to focus separately on different parts of the data manifold with varied levels of smoothness. This can affect the robustness of the learned function $f_\theta$, since the machine-learning model could be sensitive to the heterogeneity in the input data.

In an embodiment, to account for the potential heterogeneity in the data manifold, the input data in the training dataset is first clustered, as opposed to using the entire training dataset as a whole during training. In particular, the training dataset is clustered, such that each cluster has an elevated intra-cluster homogeneity, and then the weighted sum of Laplacian norms of all clusters is used as non-smoothness penalization function $g_\theta$. The weights on the Laplacian norms of the clusters train machine-learning model 334 to put unequal focus on different homogeneous subgroups of the training dataset. Mathematically, the multi-objective optimization problem to be solved becomes:

$$P: \quad \min_\theta \left( \|Y - f_\theta(X)\|^2 + \sum_{k=1}^{K} \lambda_k f_\theta(X_k)^T \mathcal{L}(X_k) f_\theta(X_k) \right)$$

or

$$P: \quad \min_\theta \left( \|Y - f_\theta(X)\|^2 + \sum_{k=1}^{K} \lambda_k f_\theta(X_k)^T \mathcal{L}(X_k) f_\theta(X_k) + h_\theta(X) \right)$$

wherein *K* is a predefined number of clusters, $X_k$ are the set of input features belonging to the *k*-th cluster, $f_\theta(X_k)^T$ is the transpose of $f_\theta(X_k)$, and $\lambda_k$ denotes the weight of the k-th cluster, with $\Sigma_k \lambda_k = 1$. Each weight $\lambda_k$ can be predefined or learnable. In the case of static weights, the weights $\lambda$ may be predefined during training using a grid search, as in hyperparameter tuning.

Any suitable clustering technique may be used, including, without limitation, K-means clustering, spectral clustering, information-based clustering, and the like. In K-means clustering, the optimal number of clusters is found using the elbow method on the inertia of clusters. The elbow method comprises plotting variation as a function of the number of clusters and picking the elbow of the curve as the number of clusters to be used. The inertia of clusters is the average, over all clusters, of the sum of squared distances of points in a cluster from the centroid of that cluster.

Spectral clustering uses the spectrum (eigenvalues) of special matrices (i.e., graph Laplacian matrix), generated from the k-nearest neighbor or the affinity graph built from the data. While spectral clustering performs better than K-means clustering in clustering data in which all members of each cluster are not close to each other in a Euclidean sense, spectral clustering can also be much slower in achieving convergence than K-means clustering. This makes spectral clustering prohibitive for large datasets.

Information-based clustering maximizes entropy of the targets and minimizes the targets, given the data. Formally, the training loss to be minimized is given by:

$$\mathcal{L}_{clust}(X) = \frac{1}{B} \sum_{i=1}^{B} H[p_{clust}(f_\theta(X_i))] - \gamma H \left[ \frac{1}{B} \sum_{i=1}^{B} p_{clust}(f_\theta(X_i)) \right]$$

wherein *B* is the number of mini-batches, $X_i$ is the *i*-th mini-batch of the input dataset *X*, *H* represents the entropy, $p_{clust}$ is the clustering probability, and $\gamma \in (0,1)$. In one particular implementation, information-based clustering yielded the best results. Thus, in an embodiment, information-based clustering is used for the clustering.

## 2.5. Bi-Level Training with Adaptive Weights

In an embodiment, each cluster's weight $\lambda_k$ is learned dynamically, so as to adapt to the overall training process for machine-learning model 334, using meta-learning. Meta-learning, or learning to learn, is the process of systematically observing how different machine-learning approaches perform on a wide range of learning tasks, and then learning from this experience or metadata, to learn new tasks faster than otherwise possible. In the context of multi-task learning, the meta-learning algorithm ensures that the performance of each task improves with experience and with the number of tasks. In an embodiment, meta-learning is applied to the disclosed multi-objective optimization problem to improve the robustness of the machine-learning model by learning the cluster weights $\lambda$ dynamically in a bi-level training process. However, in an alternative embodiment, predefined cluster weights $\lambda$ may be used.

For the problem P, which is to learn a smooth target function $f_\theta$ (e.g., for estimating fault location), the weight $\lambda_k$ of each cluster $k$ can be viewed as a hyper-parameter of the machine-learning model. Meta-learning can be applied to these hyper-parameters to adaptively learn each $\lambda_k$, where $\lambda_k = f_\omega(X_k)$.

To that end, a bi-level optimization loop is executed. In the inner loop, the base-learner, which is a regressor with parameters $\theta$, is updated. In the outer loop, the meta-learner, which is a K-class classifier with parameters $\omega$, is updated. In this case, the multi-objective optimization problem with a non-smoothness penalization function becomes:

$$P: \min_\omega \sum_{k=1}^{K} f_\omega(X_k) f_{\theta^*}(X_k)^T \mathcal{L}(X_k) f_{\theta^*}(X_k)$$

wherein

$$\theta^* = \mathrm{argmin} \| Y - f_\theta(X) \|^2 + f_\theta(X)^T \mathcal{L}(X) f_\theta(X)$$

wherein argmin refers to the arguments of the minimum. In an alternative embodiment, joint optimization may be used instead of bi-level optimization.

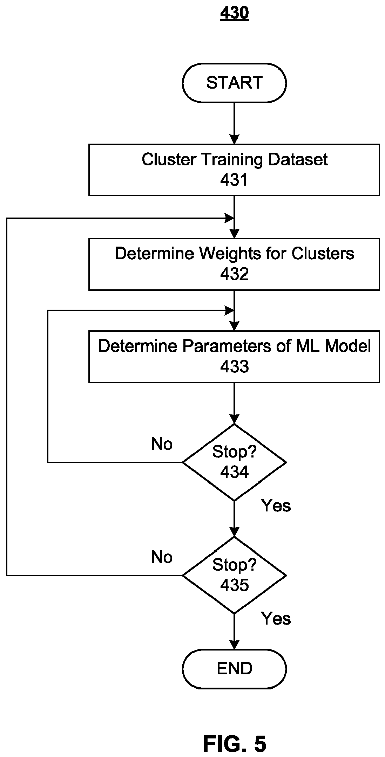

FIG. 5 illustrates an example of a training subprocess 430 which utilizes bi-level optimization, according to an embodiment. Initially, in subprocess 431, the training dataset is clustered as discussed above. Then, bi-level training begins. In particular, subprocesses 432 and 435 represent the outer loop or meta-learner, whereas subprocesses 433 and 434 represent the inner loop or base-learner. Meta-learning enhances the robustness of multi-objective learning, so that the performance of the trained models do not change widely with small variations in the input dataset.

In subprocess 432, each cluster's weight $\lambda_k$ is determined. In an initial iteration of subprocess 432, cluster weights $\lambda$ may be initialized to initial values. In each subsequent iteration of subprocess 432, the cluster weights $\lambda$ may be updated. In this case, the new cluster weights $\lambda$ may be determined using any suitable meta-learning algorithm to identify a potential set of cluster weights $\lambda$ that may further minimize the optimization problem. Examples of suitable techniques include model-agnostic meta-learning which encodes prior knowledge into trainable weight initialization, described in Finn et al., "Model-Agnostic Meta-Learning for Fast Adaptation of Deep Networks," International Conference on Machine Learning (ICML) 2017, arXiv: 1703.03400, which is hereby incorporated herein by reference as if set forth in full, and meta-learning that improves the weight update rule using random initialization to yield better generalization to new tasks during training, described in Baik et al., "Meta-Learning with Adaptive Hyperparameters," NeurIPS 2020, arXiv:2011.00209, which is hereby incorporated herein by reference as if set forth in full.

In subprocess 433, the parameters of machine-learning model 334 are determined and the error of the optimization problem is calculated. The parameters of machine-learning model 334 may comprise the weights and/or other variables in machine-learning model 334 (i.e., $f_\theta$). It should be understood that these weights are different than the weights $\lambda$ assigned to the clusters in subprocess 432. In an initial iteration of subprocess 433, the parameters of machine-learning model 334 may be initialized to initial values. In each subsequent iteration of subprocess 433, the parameters may be updated. Again, the new parameters may be determined using any suitable technique, such as Pareto optimization, to identify a potential set of parameters that may further minimize the optimization problem. An example of a suitable technique is disclosed in Sener et al., "Multi-Task Learning as Multi-Objective Optimization," in Neural Information Processing Systems (NeurIPS) 2018, arXiv:1810.04650, which is hereby incorporated herein by reference as if set forth in full.

In subprocess 434, it is determined whether or not a first stopping condition for the inner loop is satisfied. The first stopping condition may comprise a number of iterations (i.e., training epochs) of the inner loop reaching or exceeding a threshold, a change in the error of the optimization problem from the preceding iteration reaching or falling below a threshold, an error of the optimization problem reaching or falling below a threshold, a time duration of the inner loop reaching or exceeding a threshold, and/or the like. If the first stopping condition has been satisfied (i.e., "Yes" in subprocess 434), training subprocess 430 proceeds to subprocess 435. In this case, the current iteration of the inner loop has ended. If the first stopping condition has not yet been satisfied (i.e., "No" in subprocess 434), training subprocess 430 returns to subprocess 433 to update the parameters of machine-learning model 334.

In subprocess 435, it is determined whether or not a second stopping condition for the outer loop is satisfied. The second stopping condition may comprise a number of iterations of the outer loop reaching or exceeding a threshold, a change in the error of the optimization problem from the preceding iteration reaching or falling below a threshold, an error of the optimization problem reaching or falling below a threshold, a time duration of the outer loop reaching or exceeding a threshold, and/or the like. If the second stopping condition has been satisfied (i.e., "Yes" in subprocess 435), training subprocess 430 ends. In this case, machine-learning model 334 has been trained and can be validated, tested, retrained, and/or deployed. If the second stopping condition has not yet been satisfied (i.e., "No" in subprocess 435), training subprocess 430 returns to subprocess 432 to update the cluster weights $\lambda$ and execute another iteration of the inner loop.

2.6. Phasor-Deviation Penalization

Phasor-deviation penalization function $h_\theta$ provides manifold regularization that is specific to time domain protection. As mentioned above, in order for phasors to be reliably computed from a time series of voltage and current measurements, a longer time series is required than is usually feasible at the speed that a tripping decision must be made. Thus, the training dataset (e.g., acquired in subprocess 410 of process 400), which comprises short time series for the purposes of training machine-learning model 334 to accurately operate in short time frames, may be augmented with longer time series from which phasors may be reliably computed. In particular, the length of these longer time series is chosen to be sufficiently long (e.g., encompassing at least a predefined length of time), based on a realistic measurement of noise level, for good estimates of the voltage and current phasors to be computed. These longer time series are labeled with ground-truth phasor values, for example, with each ground-truth phasor value representing voltage and current phasors.

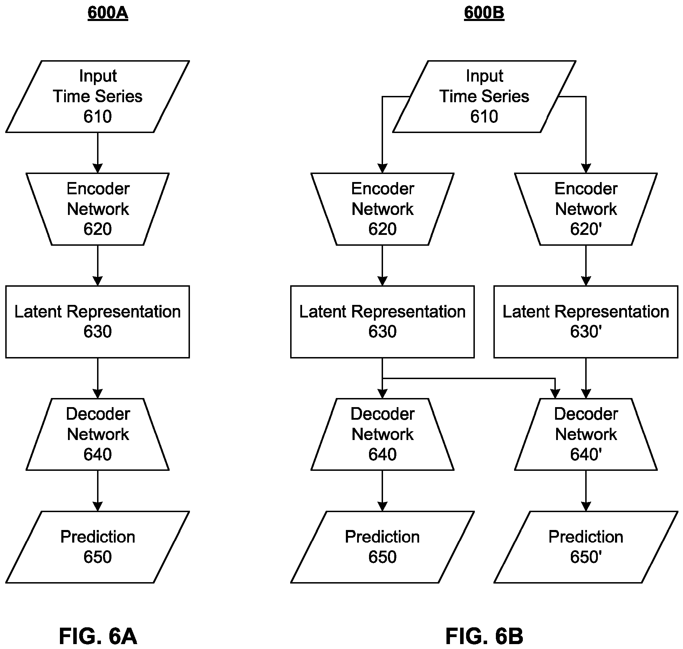

Phasor-deviation penalization function $h_\theta$ may be based on an encoder-decoder architecture. FIG. 6A illustrates an encoder-decoder architecture 600A, according to a first embodiment. According to architecture 600A, an input time series 610 is input to an encoder network 620, which produces a latent representation 630 that approximates the phasor value (e.g., voltage and current phasors) for input time series 610. Decoder network 640 may receive latent representation 630 as input, and output a prediction 650. Both encoder network 620 and decoder network 640 may comprise artificial neural networks (ANNs). Notably:

$$f_\theta(x) = d_\theta(e_\theta(x))$$

which is equivalent to:

$$f_\theta = d_\theta \circ e_\theta$$

wherein $e_\theta$ is encoder network 620, and $d_\theta$ is decoder network 640.

FIG. 6B illustrates an encoder-decoder architecture 600B, according to a second embodiment. According to architecture 600B, input time series 610 is input to two encoder networks 620 and 620'. Encoder network 620, latent representation 630, decoder network 640, and prediction 650 may be the same as in architecture 600A. Encoder network 620' may produce a latent representation 630' that captures more information contained in input time series 610 than latent representation 630, such as complex impedances, admittances, apparent power and sequence components, and/or the like. Decoder network 640' may receive both latent representation 630 and latent representation 630' as input, and output a prediction 650'. Both predictions 650 and 650' may consist of the same target, but prediction 650' will generally be more accurate, since prediction 650' is based on more information than prediction 650. Thus, the final output of architecture 600B is prediction 650'.

In an embodiment, phasor-deviation penalization function $h_\theta$ utilizes encoder network 620 to derive a latent representation 630, representing an estimated phasor value, that can be compared to a ground-truth phasor value. In particular, phasor-deviation penalization function $h_\theta$ may be defined as follows:

$$h_\theta = \sum_{(x_i,\phi_i)\forall i \in \Phi} \|e_\theta(x_i) - \phi_i\|^2$$

wherein $\Phi$ is the subset of the training dataset that consists of time series that are sufficiently long (e.g., encompassing at least a predefined length of time) to compute phasors, $x_i$ is a feature set for data instance $i$ in training subset $\Phi$, $\phi_i$ is the ground-truth phasor value for data instance $i$ in training subset $\Phi$, and $e_\theta(x_i)$ is latent representation 630 produced by encoder network 620.

Phasor-deviation penalization function $h_\theta$ is a cost function that penalizes the quadratic deviation between latent representation 630, representing the estimated phasor value $e_\theta(x_i)$, and the ground-truth phasor value $\phi_i$. Mathematically, the multi-objective optimization problem to be solved becomes:

$$P: \quad \min_\theta \left( \|Y - f_\theta(X)\|^2 + \sum_{(x_i,\phi_i)\forall i \in \Phi} \|e_\theta(x_i) - \phi_i\|^2 \right)$$

or, if combined with non-smoothness penalization function $g_\theta(X)$:

$$P: \quad \min_\theta \left( \|Y - f_\theta(X)\|^2 + g_\theta(X) + \sum_{(x_i,\phi_i)\forall i \in \Phi} \|e_\theta(x_i) - \phi_i\|^2 \right)$$

which may be embodied as

$$P: \quad \min_\theta \left( \|Y - f_\theta(X)\|^2 + \sum_{k=1}^{K} \lambda_k f_\theta(X_k)^T \mathcal{L}(X_k) f_\theta(X_k) + \sum_{(x_i,\phi_i)\forall i \in \Phi} \|e_\theta(x_i) - \phi_i\|^2 \right)$$

Phasor-deviation penalization function $h_\theta$ utilizes encoder network 620 (i.e., $e_\theta$) to attain approximated phasor values and calculate the difference between those approximated phasor values and the ground-truth phasor values. In order to minimize the estimated error of the optimization problem, encoder network 620 will also be trained, in addition to machine-learning model 334 (i.e., $f_\theta$), to produce more accurate approximations of phasor values given an input time series. Once trained, encoder network 620 will be able to approximate phasor values, regardless of the length of the input time series.

As with the Laplace regularization discussed above with respect to non-smoothness penalization function $g_\theta$, the domain-specific regularization, using phasor-deviation penalization function $h_\theta$, can be used for the regression of a fault location. However, this domain-specific regularization may alternatively be used for different learning tasks in the context of time domain protection. For example, this domain-specific regularization may be used to train machine-learning model 334 to output binary decisions of whether or not to trip circuit breaker 316.

Phasor-deviation penalization function $h_\theta$ is described as calculating the deviation between estimated and ground-truth phasor values. However, in an additional embodiment, phasor-deviation penalization function $h_\theta$ may also calculate the deviation between estimated and ground-truth values for other derived quantities, such as complex impedances, admittances, apparent power and sequence components, and/or the like.

### 3. Performance

Experiments were conducted using machine-learning model 334 with Laplace regularization for the task of fault localization in time domain protection. In particular, a regression model for estimating fault location was trained with Laplace regularization, using process 400, and without Laplace regularization. In addition, for the training with Laplace regularization, training was performed with adaptive weights, learned by a meta-learner in the bi-level training process illustrated in FIG. 5, and with predefined weights. The table below depicts an overall comparison of the mean squared error (MSE) in fault location estimation on the validation dataset, using 5-fold cross validation, for each of these trained models:

| | MSE with Laplace Regularization & Adaptive Weights | MSE with Laplace Regularization & Predefined Weights | MSE without Laplace Regularization |
|---|---|---|---|
| Fold 0 | 0.094 | 0.079 | 0.119 |
| Fold 1 | 0.061 | 0.078 | 0.105 |
| Fold 2 | 0.061 | 0.109 | 0.084 |
| Fold 3 | 0.077 | 0.072 | 0.130 |
| Fold 4 | 0.061 | 0.082 | 0.113 |
| Mean | 0.071 | 0.084 | 0.110 |
| Std. Deviation | 0.013 | 0.013 | 0.015 |
| Mean speed | 3.34 ms | 3.45 ms | 3.58 ms |

As demonstrated by the results above, the model trained with Laplace regularization and adaptive weights achieved the lowest mean MSE on the validation dataset. In addition, both of the models trained with Laplace regularization yielded lower mean MSE than the model trained without Laplace regularization. The variance of the errors, as defined by the standard deviation, was also lower for both models trained with Laplace regularization relative to the model trained without Laplace regularization. This reflects the robustness of the models, trained with Laplace regularization, against variations in initial conditions and datasets. Notably, the performance of the model that was trained with Laplace regularization and adaptive weights was more consistent across the folds than the model that was trained with Laplace regularization with predefined weights.

Unlike in typical machine-learning evaluations, accuracy alone does not reflect the need to render a proper tripping decision as fast as possible. That the problem is both causal and temporal in nature creates asymmetry in the decision-making at each sample, since the model can only use past trajectories and a single crossing of a threshold (e.g., on a fault location) to determine when to trip circuit breaker 316. Therefore, the accuracy should be evaluated using the overall trip decision. Since the output of the model, in an embodiment, is the location of a fault, this output is compared to a threshold (e.g., reach setting 336) defining the protection zone. If an actual fault location is close to the reach setting 336, the decision outcome might not be perfect. Therefore, each model was assessed by calculating how far the fault must be from reaching setting 336 before the overall trip decision is perfect. The range around the reach setting 336 in which a model makes imperfect decisions may be referred to as the "blind zone" for that reach setting 336. In the blind zone, there is at least one input that produces a miss operation (i.e., a false negative) or a mal operation (i.e., a false positive). The blind zone captures the total width of the range encompassing erroneous estimates representing false positives or false negatives. It should be understood that a more accurate model will yield a narrower blind zone than a less accurate model. A blind zone whose width is zero would indicate a model that makes perfect decisions for all cases.

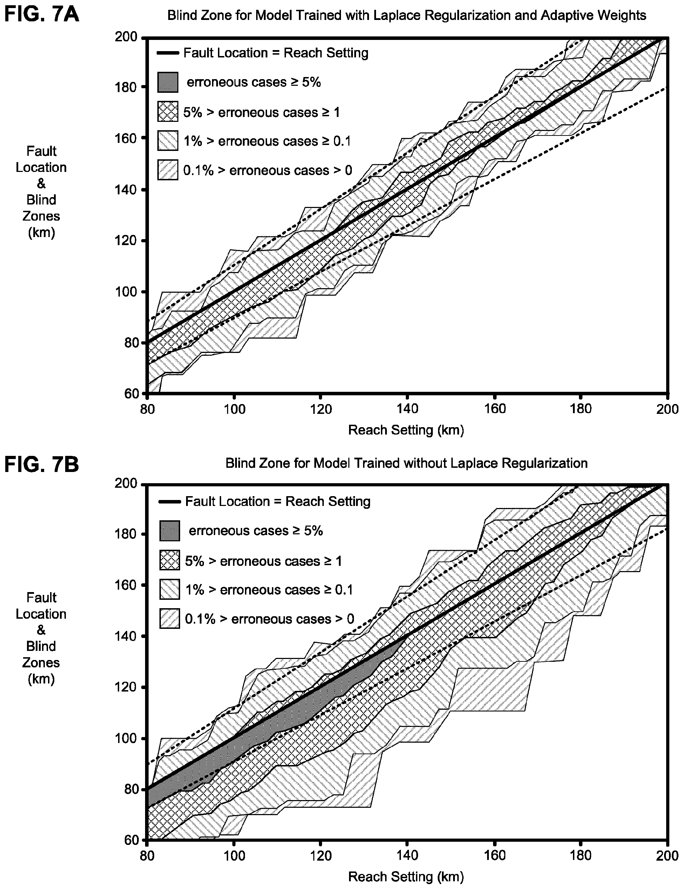

FIG. 7A illustrates the blind zone for a machine-learning model 334 that is trained using Laplace regularization and adaptive weights, according to an embodiment, whereas FIG. 7B illustrates the blind zone for a model that is trained without Laplace regularization. The models were tested for different reach settings and fault locations. Each band of the blind zones indicates a percentile of erroneous estimates. The illustrated bands represent percentiles of greater than 5%, between 1% and 5%, between 0.1% and 1.0%, and greater than 0% but less than 0.1%. The dashed lines represent user-specified boundaries on the erroneous estimates, and the bold black line represents instances in which the fault location is exactly equal to reach setting 336. Cases above the bold black line represent instances in which a fault location is greater than reach setting 336 (i.e., outside the protection zone), and therefore, for which line protection system 330 should not trip circuit breaker 316. Conversely, cases below the bold black line represent instances in which a fault location is less than reach setting 336 (i.e., within the protection zone), and therefore, for which line protection system 330 should trip circuit breaker 316. As is apparent from FIGS. 7A and 7B, the machine-learning model 334 that was trained using Laplace regularization and adaptive weights outperforms the model that was not trained using Laplace regularization, in terms of having a narrower blind zone. Although not shown, the machine-learning model 334 that is trained using Laplace regularization and adaptive weights also outperforms a machine-learning model 334 that is trained using Laplace regularization with predefined weights, in terms of having a narrower blind zone.

Improvements were also obtained in terms of speed. In particular, the mean speed of inference by the model with Laplace regularization and adaptive weights was 3.34 milliseconds, which was faster than the mean speeds of 3.45 milliseconds for the model with Laplace regularization and predefined weights and 3.58 milliseconds for the model without Laplace regularization. These times include the delay caused by applying a security counter to the output of the tested models.

In summary, in terms of both accuracy and speed, the model trained with Laplace regularization and adaptive weights outperformed the model trained with Laplace regularization and predefined weights, and both models trained with Laplace regularization outperformed the model trained without Laplace regularization.

4. Example Embodiment

Disclosed embodiments frame the training of a machine-learning model 334 as a multi-objective optimization problem. In addition to the primary objective function that calculates an error of machine-learning model 334 (e.g., as a regression task), the multi-objective optimization problem comprises a non-smoothness penalization function $g_\theta$, which drives the primary objective function to a solution that respects smoothness between the inputs and outputs of machine-learning model 334. In particular, parts of the data that contribute to the non-smoothness of the data manifold, resulting in a high gradient, are penalized during training. To facilitate this, the gradient of the neighboring graph, formed from the data, may be added to the MSE loss, which measures the reconstruction error. As discussed herein, training machine-learning model 334 in this manner improves the performance of machine-learning model 334 in at least four ways: (i) a lower mean squared error; (ii) a narrower blind zone; (iii) enhanced robustness; and (iv) a lower mean speed.

This Laplace regularization, using non-smoothness penalization function $g_\theta$, with or without adaptive weights for clusters, can be employed in any regression task in which the data are heterogeneous and the regression function is foreseen to be smooth on the data (i.e., the regression function does not vary abruptly with the data points). Apart from the application of fault localization in time domain protection, other potential areas of application include, without limitation, power state estimation, topology estimation, parameter estimation (e.g., grid inertia), power flow estimation, load forecasting, and the like. In such scenarios, Laplace regularization will be particularly advantageous if the data have a high degree of heterogeneity (e.g., the input signals are gathered from different towers or other sources).

Additionally or alternatively to a non-smoothness penalization function $g_\theta$, the multi-objective optimization problem may comprise a phasor-deviation penalization function $h_\theta$, which utilizes an encoder network 620 to drive the primary objective function to a solution that minimizes a deviation in phasor values, and optionally, other derived quantities. This domain-specific regularization improves the regressor by learning to derive phasors from time series (e.g., of voltages and currents). This information is valuable for the specific application of time domain protection, but is difficult to compute from short time series corresponding to the fast decision times that are desired for time domain protection.

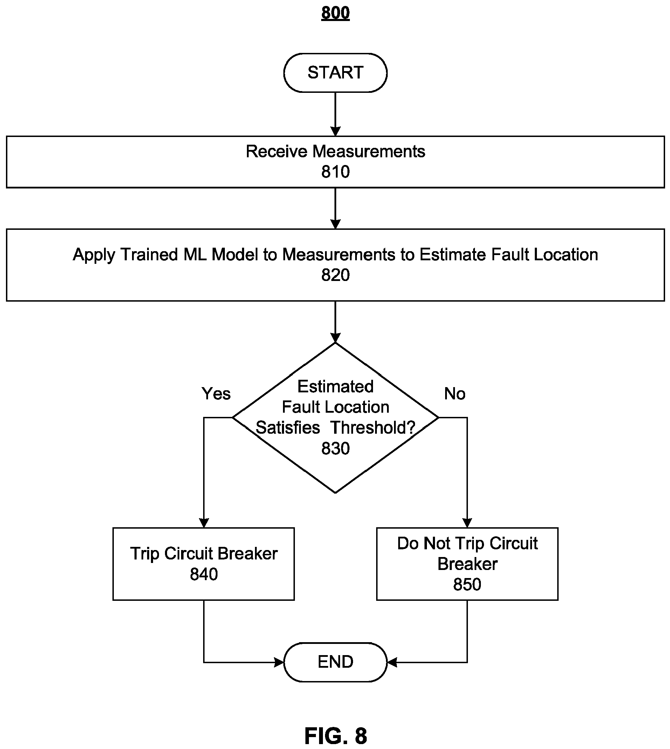

FIG. 8 illustrates a process 800 for making a trip decision, according to an embodiment in which machine-learning model 334 is used to estimate the location of a fault. In subprocess 810, controller 332 of line protection system 330, acting as a protection device, may receive measurements signals from a plurality of sensors connected to power line 310. For example, these measurement signals may comprise or consist of values of voltage measured by voltage measurement unit 312 and current measured by current measurement unit 314. In subprocess 820, controller 332 may apply the trained machine-learning model 334 to the measurement signals to estimate a location of a fault 340 on power line 310. Then, in subprocess 830, controller 332 may compare the estimated fault location to a predetermined threshold, representing reach setting 336. For example, controller 332 may determine whether the estimated fault location is less than or equal to reach setting 336. When determining that the estimated fault location satisfies the threshold (i.e., "Yes" in subprocess 830), indicating that fault 340 is within the protection zone defined by reach setting 336, controller 332 may trip circuit breaker 316 in subprocess 840 to electrically isolate the fault location on power line 310. Otherwise, when determining that the estimated fault location does not satisfy the threshold (i.e., "No" in subprocess 830), controller 332 determines not to trip circuit breaker 316 in subprocess 850.

In an alternative embodiment in which the output of machine-learning model 334 is a trip decision, rather than an estimated fault location, controller 332 may apply the trained machine-learning model 334 to the measurement signals to determine whether or not to trip circuit breaker 316. It should be understood that, in this case, the measurement signals may be the same as described above. During training of machine-learning model 334, the feature sets will represent sets of such measurement signals, and each target value will represent a decision to either trip or not trip a circuit breaker. Thus, in this embodiment, machine-learning model 334 is a binary classifier.

Embodiment 1: A method of manifold regularization while training a machine-learning model, the method comprising using at least one hardware processor to: acquire a training dataset that comprises a plurality of feature sets, wherein each of the plurality of feature sets comprises a feature value for each of a plurality of features and is labeled with a target value for each of one or more targets; generate an optimization problem comprising an objective function and a non-smoothness penalization function, wherein the objective function calculates an estimated error between the target values and corresponding output values that the machine-learning model outputs for the plurality of feature sets, and wherein the non-smoothness penalization function is configured to increase the estimated error in the optimization problem as a smoothness of the machine-learning model decreases; and train the machine-learning model by adjusting the machine-learning model to minimize the estimated error, produced by the training dataset, in the optimization problem.

Embodiment 2: The method of Embodiment 1, wherein the non-smoothness penalization function comprises a Laplacian norm of the output values.

Embodiment 3: The method of any preceding embodiment, wherein the non-smoothness penalization function approximates a gradient of the machine-learning model on a data manifold of the machine-learning model.

Embodiment 4: The method of any preceding embodiment, wherein training the machine-learning model comprises: clustering the training dataset into a plurality of clusters, wherein the non-smoothness penalization function associates a weight with each of the plurality of clusters; and adaptively learning the weights for the plurality of clusters.

Embodiment 5: The method of Embodiment 4, wherein adaptively learning the weights for the plurality of clusters comprises, for each of a plurality of outer iterations: determining the weights for the plurality of clusters; and for each of a plurality of inner iterations, adjusting the machine-learning model to minimize the estimated error, produced by the training dataset, in the optimization problem, using the determined weights for the plurality of clusters in the non-smoothness penalization function.

Embodiment 6: The method of Embodiment 5, wherein the weights for the plurality of clusters are determined in each of the plurality of outer iterations using a multi-class classification algorithm.

Embodiment 7: The method of Embodiment 6, wherein the machine-learning model is adjusted in each of the plurality of inner iterations using a regression algorithm.

Embodiment 8: The method of any preceding embodiment, further comprising using the at least one hardware processor to, prior to acquiring the training dataset, acquire data having a first dimensionality, and embed the data into a lower dimensional space having a second dimensionality that is lower than the first dimensionality, wherein the training dataset is acquired from the data in the lower dimensional space.

Embodiment 9: The method of any preceding embodiment, wherein each of the plurality of feature sets represents a set of measurement signals for a power line, and wherein each target value represents a fault location on the power line.

Embodiment 10: The method of Embodiment 9, further comprising, by a protection device: receiving measurement signals from a plurality of sensors connected to the power line; applying the trained machine-learning model to the measurement signals to estimate a fault location on the power line; comparing the estimated fault location to a threshold; and when the estimated fault location satisfies the threshold, tripping at least one circuit breaker to electrically isolate the fault location on the power line.

Embodiment 11: The method of any preceding embodiment, wherein each of the plurality of feature sets represents a set of measurement signals for a power line, and wherein each target value represents a decision to either trip or not trip a circuit breaker on the power line.

Embodiment 12: The method of any preceding embodiment, wherein each of the plurality of feature sets represents a state of a power system, wherein each target value represents a value of a continuous variable of the power system, and wherein the method further comprises using the trained machine-learning model to estimate the value of the continuous variable.

Embodiment 13: The method of any preceding embodiment, further comprising using the trained machine-learning model for one of topology estimation, parameter estimation, power flow estimation, or load forecasting.

Embodiment 14: The method of any preceding embodiment, wherein each of at least a subset of the plurality of feature sets in the training dataset is labeled with a ground-truth phasor value, wherein the optimization problem further comprises a phasor-deviation penalization function that is configured to increase the estimated error in the optimization problem as a difference between an estimated phasor value, output by an encoder network, and the ground-truth phasor value, for each of the at least a subset of the plurality of features sets in the training dataset, increases.

Embodiment 15: The method of Embodiment 14, wherein the at least a subset of the plurality of feature sets in the training dataset consists of only a portion of the plurality of feature sets in the training dataset that comprises, for each of the plurality of features, a time series that encompasses at least a predefined length of time.

Embodiment 16: The method of Embodiment 14 or 15, wherein the encoder network is an artificial neural network.

Embodiment 17: A system comprising: at least one hardware processor; and software configured to, when executed by the at least one hardware processor, perform the method of any one of Embodiments 1 through 16.

Embodiment 18: A non-transitory computer-readable medium having instructions stored thereon, wherein the instructions, when executed by a processor, cause the processor to perform the method of any one of Embodiments 1 through 16.

Embodiment 19: A method of manifold regularization while training a machine-learning model, the method comprising using at least one hardware processor to: acquire a training dataset that comprises a plurality of feature sets, wherein each of the plurality of feature sets comprises a feature value for each of a plurality of features and is labeled with a target value for each of one or more targets, and wherein each of at least a subset of the plurality of feature sets is labeled with a ground-truth phasor value; generate an optimization problem comprising an objective function and a phasor-deviation penalization function, wherein the objective function calculates an estimated error between the target values and corresponding output values that the machine-learning model outputs for the plurality of feature sets, and wherein the phasor-deviation penalization function is configured to increase the estimated error in the optimization problem as a difference between an estimated phasor value, output by an encoder network, and a ground-truth phasor value, for each of the at least a subset of the plurality of features sets in the training dataset, increases; and train the machine-learning model by adjusting the machine-learning model to minimize the estimated error, produced by the training dataset, in the optimization problem.

Embodiment 20: The method of Embodiment 19, wherein the at least a subset of the plurality of feature sets in the training dataset consists of only a portion of the plurality of feature sets in the training dataset that comprises, for each of the plurality of features, a time series that encompasses at least a predefined length of time.

Embodiment 21: A system comprising: at least one hardware processor; and software configured to, when executed by the at least one hardware processor, perform the method of Embodiment 19 or 20.

Embodiment 22: A non-transitory computer-readable medium having instructions stored thereon, wherein the instructions, when executed by a processor, cause the processor to perform the method of Embodiment 19 or 20.

The above description of the disclosed embodiments is provided to enable any person skilled in the art to make or use the invention. Various modifications to these embodiments will be readily apparent to those skilled in the art, and the general principles described herein can be applied to other embodiments without departing from the spirit or scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly not limited.

Combinations, described herein, such as "at least one of A, B, or C," "one or more of A, B, or C," "at least one of A, B, and C," "one or more of A, B, and C," and "A, B, C, or any combination thereof' include any combination of A, B, and/or C, and may include multiples of A, multiples of B, or multiples of C. Specifically, combinations such as "at least one of A, B, or C," "one or more of A, B, or C," "at least one of A, B, and C," "one or more of A, B, and C," and "A, B, C, or any combination thereof' may be A only, B only, C only, A and B, A and C, B and C, or A and B and C, and any such combination may contain one or more members of its constituents A, B, and/or C. For example, a combination of A and B may comprise one A and multiple B's, multiple A's and one B, or multiple A's and multiple B's.

## Claims

1. A method of manifold regularization while training a machine-learning model, the method comprising using at least one hardware processor to:

   acquire a training dataset that comprises a plurality of feature sets, wherein each of the plurality of feature sets comprises a feature value for each of a plurality of features and is labeled with a target value for each of one or more targets;
   generate an optimization problem comprising an objective function and a non-smoothness penalization function, wherein the objective function calculates an estimated error between the target values and corresponding output values that the machine-learning model outputs for the plurality of feature sets, and wherein the non-smoothness penalization function is configured to increase the estimated error in the optimization problem as a smoothness of the machine-learning model decreases; and
   train the machine-learning model by adjusting the machine-learning model to minimize the estimated error, produced by the training dataset, in the optimization problem.

2. The method of Claim 1, wherein the non-smoothness penalization function comprises a Laplacian norm of the output values.

3. The method of Claim 1, wherein the non-smoothness penalization function approximates a gradient of the machine-learning model on a data manifold of the machine-learning model.

4. The method of Claim 1, wherein training the machine-learning model comprises:

clustering the training dataset into a plurality of clusters, wherein the non-smoothness penalization function associates a weight with each of the plurality of clusters; and
adaptively learning the weights for the plurality of clusters.

5. The method of Claim 4, wherein adaptively learning the weights for the plurality of clusters comprises, for each of a plurality of outer iterations:

determining the weights for the plurality of clusters; and
for each of a plurality of inner iterations, adjusting the machine-learning model to minimize the estimated error, produced by the training dataset, in the optimization problem, using the determined weights for the plurality of clusters in the non-smoothness penalization function.

6. The method of Claim 5, wherein the weights for the plurality of clusters are determined in each of the plurality of outer iterations using a multi-class classification algorithm.

7. The method of Claim 6, wherein the machine-learning model is adjusted in each of the plurality of inner iterations using a regression algorithm.

8. The method of Claim 1, further comprising using the at least one hardware processor to, prior to acquiring the training dataset, acquire data having a first dimensionality, and embed the data into a lower dimensional space having a second dimensionality that is lower than the first dimensionality, wherein the training dataset is acquired from the data in the lower dimensional space.

9. The method of Claim 1, wherein each of the plurality of feature sets represents a set of measurement signals for a power line, and wherein each target value represents a fault location on the power line.

10. The method of Claim 9, further comprising, by a protection device:

receiving measurement signals from a plurality of sensors connected to the power line;
applying the trained machine-learning model to the measurement signals to estimate a fault location on the power line;
comparing the estimated fault location to a threshold; and
when the estimated fault location satisfies the threshold, tripping at least one circuit breaker to electrically isolate the fault location on the power line.

11. The method of Claim 1, wherein each of the plurality of feature sets represents a set of measurement signals for a power line, and wherein each target value represents a decision to either trip or not trip a circuit breaker on the power line.

12. The method of Claim 1, wherein each of the plurality of feature sets represents a state of a power system, wherein each target value represents a value of a continuous variable of the power system, and wherein the method further comprises using the trained machine-learning model to estimate the value of the continuous variable.

13. The method of Claim 1, further comprising using the trained machine-learning model for one of topology estimation, parameter estimation, power flow estimation, or load forecasting.

14. The method of Claim 1, wherein each of at least a subset of the plurality of feature sets in the training dataset is labeled with a ground-truth phasor value, wherein the optimization problem further comprises a phasor-deviation penalization function that is configured to increase the estimated error in the optimization problem as a difference between an estimated phasor value, output by an encoder network, and the ground-truth phasor value, for each of the at least a subset of the plurality of features sets in the training dataset, increases.

15. The method of Claim 14, wherein the at least a subset of the plurality of feature sets in the training dataset consists of only a portion of the plurality of feature sets in the training dataset that comprises, for each of the plurality of features, a time series that encompasses at least a predefined length of time.

16. The method of Claim 14, wherein the encoder network is an artificial neural network.

**17.** A system comprising:

at least one hardware processor; and
software configured to, when executed by the at least one hardware processor,

acquire a training dataset that comprises a plurality of feature sets, wherein each of the plurality of feature sets comprises a feature value for each of a plurality of features and is labeled with a target value for each of one or more targets,

generate an optimization problem comprising an objective function and a non-smoothness penalization function, wherein the objective function calculates an estimated error between the target values and corresponding output values that the machine-learning model outputs for the plurality of feature sets, and wherein the non-smoothness penalization function is configured to increase the estimated error in the optimization problem as a smoothness of the machine-learning model decreases, and

train the machine-learning model by adjusting the machine-learning model to minimize the estimated error, produced by the training dataset, in the optimization problem.

**18.** The system of Claim 17, wherein each of at least a subset of the plurality of feature sets in the training dataset is labeled with a ground-truth phasor value, wherein the optimization problem further comprises a phasor-deviation penalization function that is configured to increase the estimated error in the optimization problem as a difference between an estimated phasor value, output by an encoder network, and the ground-truth phasor value, for each of the at least a subset of the plurality of features sets in the training dataset, increases.

**19.** A method of manifold regularization while training a machine-learning model, the method comprising using at least one hardware processor to:

acquire a training dataset that comprises a plurality of feature sets, wherein each of the plurality of feature sets comprises a feature value for each of a plurality of features and is labeled with a target value for each of one or more targets, and wherein each of at least a subset of the plurality of feature sets is labeled with a ground-truth phasor value;

generate an optimization problem comprising an objective function and a phasor-deviation penalization function, wherein the objective function calculates an estimated error between the target values and corresponding output values that the machine-learning model outputs for the plurality of feature sets, and wherein the phasor-deviation penalization function is configured to increase the estimated error in the optimization problem as a difference between an estimated phasor value, output by an encoder network, and a ground-truth phasor value, for each of the at least a subset of the plurality of features sets in the training dataset, increases; and

train the machine-learning model by adjusting the machine-learning model to minimize the estimated error, produced by the training dataset, in the optimization problem.

**20.** The method of Claim 19, wherein the at least a subset of the plurality of feature sets in the training dataset consists of only a portion of the plurality of feature sets in the training dataset that comprises, for each of the plurality of features, a time series that encompasses at least a predefined length of time.

FIG. 1

**200**

**FIG. 2**

Communication
Bus
205

Processor
210

Main Memory
215

I/O Interface
235

Communication
Interface 240

Baseband
260

Radio
265

Antenna
270

Secondary
Memory 220

Internal Medium
225

Removable
Medium
230

255

250

External Medium
245

Line Protection System
330

Controller
332

ML Model
334

312

340

V

A

CB
316

310

320A

314

320B

336

**FIG. 3**

<u>400</u>

START

Acquire Training Dataset
410

Generate Optimization Problem with Objective Function and Non-Smoothness Penalization Function and/or Phasor-Deviation Penalization Function
420

Train Machine-Learning Model by Minimizing Error in Optimization Problem
430

END

**FIG. 4**

<u>430</u>

```
                    ┌──────────┐
                    │  START   │
                    └────┬─────┘
                         │
                         ▼
              ┌──────────────────────────┐
              │  Cluster Training Dataset │
              │           431            │
              └──────────┬───────────────┘
                         │
                         ▼
              ┌──────────────────────────┐
              │ Determine Weights for     │
              │       Clusters           │
              │           432            │
              └──────────┬───────────────┘
                         │
                         ▼
              ┌──────────────────────────┐
              │ Determine Parameters of   │
              │        ML Model          │
              │           433            │
              └──────────┬───────────────┘
                         │
                         ▼
              No       ◇ Stop? ◇
              ◄────────  434
                         │ Yes
                         ▼
              No       ◇ Stop? ◇
              ◄────────  435
                         │ Yes
                         ▼
                    ┌──────────┐
                    │   END    │
                    └──────────┘
```

**FIG. 5**

**600A**

**600B**

FIG. 6A

FIG. 6B

## FIG. 7A

Blind Zone for Model Trained with Laplace Regularization and Adaptive Weights

Fault Location & Blind Zones (km)

— Fault Location = Reach Setting

erroneous cases ≥ 5%

5% > erroneous cases ≥ 1

1% > erroneous cases ≥ 0.1

0.1% > erroneous cases > 0

Reach Setting (km)

## FIG. 7B

Blind Zone for Model Trained without Laplace Regularization

Fault Location & Blind Zones (km)

— Fault Location = Reach Setting

erroneous cases ≥ 5%

5% > erroneous cases ≥ 1

1% > erroneous cases ≥ 0.1

0.1% > erroneous cases > 0

Reach Setting (km)

800

```
              ┌─────────────┐
              │    START    │
              └──────┬──────┘
                     │
                     ▼
   ┌────────────────────────────────────────────────┐
   │            Receive Measurements                 │
   │                    810                          │
   └────────────────────┬───────────────────────────┘
                        │
                        ▼
   ┌────────────────────────────────────────────────┐
   │  Apply Trained ML Model to Measurements to      │
   │            Estimate Fault Location              │
   │                    820                          │
   └────────────────────┬───────────────────────────┘
                        │
                        ▼
                    Estimated
      Yes           Fault Location          No
   ◄───────    Satisfies  Threshold?    ───────►
                        830
```

Yes → Estimated Fault Location Satisfies Threshold? 830 → No

Trip Circuit Breaker
840

Do Not Trip Circuit
Breaker
850

END

## FIG. 8

# EUROPEAN SEARCH REPORT

**Application Number**

EP 22 20 0674

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG XUEQIN ET AL: "Fault diagnosis method for hybrid HVDC transmission system based on stacked sparse auto-encoder", 2022 7TH ASIA CONFERENCE ON POWER AND ELECTRICAL ENGINEERING (ACPEE), IEEE, 15 April 2022 (2022-04-15), pages 1771-1776, XP034130364, DOI: 10.1109/ACPEE53904.2022.9783919 [retrieved on 2022-06-01] * page 1772 – page 1774 * | 1-18 | INV. G06N3/0455 G06N3/09 G01R19/25 G05B23/02 H02J13/00 G01R31/08 |
| X | WENTING LI ET AL: "Real-time Fault Localization in Power Grids With Convolutional Neural Networks", ARXIV.ORG, CORNELL UNIVERSITY LIBRARY, 201 OLIN LIBRARY CORNELL UNIVERSITY ITHACA, NY 14853, 11 October 2018 (2018-10-11), XP081064720, * page 1 – page 4 * | 1-18 | |
| X | US 2022/057759 A1 (POLAND JAN [CH] ET AL) 24 February 2022 (2022-02-24) * paragraph [0001] * * paragraph [0023] – paragraph [0024] * * figure 5 * | 1-18 | TECHNICAL FIELDS SEARCHED (IPC) G06N G01R G05B H02J |
| A | LEI YONGXIANG ET AL: "A Hybrid Regularization Semi-Supervised Extreme Learning Machine Method and Its Application", IEEE ACCESS, vol. 7, 19 February 2019 (2019-02-19), pages 30102-30111, XP011715587, DOI: 10.1109/ACCESS.2019.2900267 [retrieved on 2019-03-18] * Section II.C; page 30104 * | 1-7,17 | |

-/--

The present search report has been drawn up for all claims

| Place of search | Date of completion of the search | Examiner |
|---|---|---|
| The Hague | 9 May 2023 | Bohn, Patrice |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 22 20 0674

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AHMED ARMAN ET AL: "Cyber Physical Security Analytics for Anomalies in Transmission Protection Systems", IEEE TRANSACTIONS ON INDUSTRY APPLICATIONS, IEEE SERVICE CENTER, PISCATAWAY, NJ, US, vol. 55, no. 6, 1 November 2019 (2019-11-01), pages 6313-6323, XP011755097, ISSN: 0093-9994, DOI: 10.1109/TIA.2019.2928500 [retrieved on 2019-11-11] * page 6313 - page 6317 * ----- | 19,20 | |

TECHNICAL FIELDS
SEARCHED       (IPC)

The present search report has been drawn up for all claims

| Place of search | Date of completion of the search | Examiner |
|---|---|---|
| The Hague | 9 May 2023 | Bohn, Patrice |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

EPO FORM 1503 03.82 (P04C01)

Europäisches
Patentamt

European
Patent Office

Office européen
des brevets

Application Number

**EP 22 20 0674**

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

**Application Number**

**EP 22 20 0674**

The Search Division considers that the present European patent application does not comply with the
requirements of unity of invention and relates to several inventions or groups of inventions, namely:

    **1. claims: 1-18**

        **precise estimation of fault location in a power system**
        ---

    **2. claims: 19, 20**

        **power system voltage/current state estimation**
        ---

## ANNEX TO THE EUROPEAN SEARCH REPORT
## ON EUROPEAN PATENT APPLICATION NO.

EP 22 20 0674

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2023

| Patent document cited in search report | | Publication date | Patent family member(s) | | Publication date |
|---|---|---|---|---|---|
| US 2022057759 | A1 | 24-02-2022 | CN | 114077810 A | 22-02-2022 |
| | | | EP | 3958423 A1 | 23-02-2022 |
| | | | JP | 2022036032 A | 04-03-2022 |
| | | | US | 2022057759 A1 | 24-02-2022 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **FINN et al.** Model-Agnostic Meta-Learning for Fast Adaptation of Deep Networks. *arXiv: 1703.03400,* 2017

- **BAIK et al.** Meta-Learning with Adaptive Hyperparameters. *arXiv:2011.00209,* 2020
- **SENER et al.** Multi-Task Learning as Multi-Objective Optimization. *arXiv:1810.04650,* 2018